# EUROPÄISCHE PATENTSCHRIFT

(11) **EP 0 890 204 B1**
(45) Veröffentlichungstag und Bekanntmachung des Hinweises auf die Patenterteilung: **22.12.1999**
(21) Anmeldenummer: 97920587.9
(22) Anmeldetag: 27.03.1997
(51) Int. Cl.: H01S 3/103, H01S 3/11, H01S 3/085

(54) **GÜTEGESTEUERTER HALBLEITERLASER**
Q-SWITCHED SEMICONDUCTOR LASER
LASER A SEMICONDUCTEUR DECLENCHE

(30) Priorität: 29.03.1996 DE 19613704
(43) Veröffentlichungstag der Anmeldung: 13.01.1999
(73) Patentinhaber: Heinrich-Hertz-Institut für Nachrichtentechnik Berlin GmbH, 10587 Berlin (DE)
(72) Erfinder: SARTORIUS, Bernd, D-14052 Berlin (DE); MÖHRLE, Martin, D-12355 Berlin (DE)
(74) Vertreter: Rudolph, Margit
(86) Internationale Anmeldenummer: DE9700696
(87) Internationale Veröffentlichungsnummer: WO9737406

(56) Entgegenhaltungen:
- US-A- 4 982 405
- IEEE PHOTONICS TECHNOLOGY LETTERS, Bd. 8, Nr. 1, 1.Januar 1996, Seiten 28-30, XP000547524 MOEHRLE M ET AL: "ELECTRICALLY SWITCHABLE SELF-PULSATIONS IN INTEGRATABLE MULTISECTION DFB-LASER" in der Anmeldung erwähnt
- IEEE JOURNAL OF QUANTUM ELECTRONICS, Bd. 30, Nr. 5, 1.Mai 1994, Seiten 1204-1211, XP000455159 DODS S R A ET AL: "Q-MODULATION OF A SURFACE EMITTING LASER AND AN INTEGRATED DETUNED CAVITY"
- PATENT ABSTRACTS OF JAPAN vol. 095, no. 002, 31.März 1995 & JP 06 314846 A (NEC CORP), 8.November 1994,
- PATENT ABSTRACTS OF JAPAN vol. 010, no. 133 (E-404), 17.Mai 1986 & JP 60 263490 A (MATSUSHITA DENKI SANGYO KK), 26.Dezember 1985,

## Beschreibung

Die Erfindung bezieht sich auf einen gütegesteuerten Halbleiterlaser, bestehend aus mindestens zwei elektrisch getrennten aber optisch gekoppelten Resonatoren, von denen der eine als passiver und der andere als aktiver Resonator ausgebildet ist.

Die Anwendung gütegesteuerter Halbleiterlaser liegt aufgrund der Möglichkeit, mit diesen Anordnungen kurze und intensive Laserpulse zu erzeugen, u.a. auf dem Gebiet der nichtlinearen Optik und der Nachrichtenübertragung/optischen Informationsübertragung.

Bei einem gütegesteuerten Laser wird durch starkes Pumpen eine hohe Besetzungsinversion aufgebaut und so eine hohe Verstärkung erreicht. Durch große Resonatorverluste wird aber das Einsetzen der Lasertätigkeit zunächst verhindert. Werden die Verluste ausgeschaltet, wird ein kurzer Lichtpuls hoher Impulsleistung emittiert. Zum Güteschalten können einmal die externen Verluste an den Resonatorspiegeln verändert werden oder es werden interne Verluste im Resonator zunächst erzeugt, die dann aber ausgeschaltet werden können.

In IEEE Photonics Technology Letters, Vol. 7, No. 10, October 1995, pp. 1125-1127 ist ein Zwei-Sektions-DFB-Laser beschrieben, bei dem eine Sektion zunächst als Absorber betrieben und dann durch Strominjektion transparent gemacht wird. Hierbei wird die Netto-Verstärkung innerhalb des Resonators moduliert. Im Vergleich zur Modulation eines Lasers über den Pumpstrom werden mit dieser Anordnung bereits Verbesserungen in den benötigten Modulationsströmen und im Chirp erreicht. Jedoch ist eine hochfrequente Lasermodulation mit geringen Strömen bzw. Spannungshüben bisher noch nicht realisiert worden.

In US-PS 4982 405 ist ein gütemodulierter Laser mit zwei optisch gekoppelten Resonatoren beschrieben. Die Q-Modulation erfolgt hierbei durch Verstimmung der beiden Resonatoren.

Der Stand der Technik, von dem die Erfindung ausgeht, ist in IEEE Journal of Quantum Electronics 30 (1994) May, No. 5, pp. 1204 - 1211 beschrieben. Der dargestellte gütemodulierte Halbleiterlaser besteht aus zwei optisch gekoppelten Resonatoren, von denen der eine als passiver und der andere als aktiver Resonator ausgebildet ist. Beide Resonatoren sind elektrisch ansteuerbar (Elektroden an den Spiegeln, Mittelelektrode für beide Resonatoren gemeinsam), wodurch getrennt die aktive Sektion gepumpt (Erzeugung der Verstärkung) und die passive Sektion im Brechungsindex elektrisch abgestimmt werden kann. Auch bei dieser Lösung erfolgt die als Q-Modulation bezeichnete Leistungsmodulation durch Verstimmung der beiden Resonatoren. Der Bereich mit variierbarem Brechungsindex wirkt hierbei gemeinsam mit den beiden diesen Bereich einschließenden Bragg-Reflektoren als variabler Reflektor oder als abstimmbares Etalon. Als Resonatorspiegel sind hierbei DBR-Reflektoren als Spiegel wegen ihrer besonders hohen und innerhalb des Stop-Bandes nahezu konstanten Reflektivität eingesetzt. In dieser Anordnung wirkt die DBR-Struktur bei der Laserwellenlänge ausschließlich als Spiegel hoher Reflektivität. Diese dem Stand der Technik nach bekannten Lösungen erlauben zwar eine hochfrequente Q-Modulation der Laser, aber nur mit geringem Modulationshub.

Deshalb ist es Aufgabe der Erfindung, einen gütegesteuerten Laser anzugeben, der eine hochfrequente Lasermodulation mit geringen Strömen bzw. Spannungshüben ermöglicht.

Die Aufgabe wird dadurch gelöst, daß bei einem gütegesteuerten Halbleiterlaser der eingangs erwähnten Art erfindungsgemäß die beiden optisch gekoppelten Resonatoren zur Lasermoden-Selektion unterschiedlich ausgebildete Modenkämme aufweisen, die sich spektral so überlappen, daß eine definierte Laserwellenlänge selektiert wird, mindestens ein Resonatorspiegel der beiden optisch gekoppelten Resonatoren als Reflektor mit einer stark dispersiven Reflexionscharakteristik im Bereich der durch die beiden optisch gekoppelten Resonatoren selektierten Laserwellenlänge ausgebildet ist, Mittel zur elektrischen oder optischen Abstimmung des Brechungsindex des dispersiven Reflektors und/oder des passiven Resonators vorgesehen sind, so daß eine spektrale Steuerung der Lasermode relativ zum dispersiven Reflektor erfolgt.

Mit dieser Anordnung kann die Reflektivität für die Laserwellenlänge so eingestellt werden, daß bei fester effektiver Verstärkung durch elektrische Modulation der Reflektivität des Resonatorspiegels mit stark dispersiver Reflexionscharakteristik die Laserschwelle so abgesenkt oder angehoben werden kann, daß der Halbleiterlaser dadurch ein- oder ausgeschaltet wird.

Eine ähnliche Anordnung wird bereits in IEEE Photonics Technology Letters, Vol. 8, No. 1, January 1990, pp 28 - 30 beschrieben. Dieser Mehrsektionslaser wird aber anders betrieben und hat eine andere Funktion als die vorliegende Lösung. So wird in dem selbstpulsierenden Mehrsektionslaser die aktive Schicht so stark gepumpt, d.h. mit einem solch hohen Strom angesteuert, daß der aktive Resonator bereits alleine als Laser anschwingt. Die Ströme im passiven Resonator und im Reflektor sind - im Gegensatz zum Betrieb des erfindungsgemäßen Lasers - fixiert, und zwar auf solche Werte, daß ein Rauschen der Ladungsträgerdichte im aktiven Resonator, das zu einem Rauschen der Laserwellenlänge führt, sich durch die wellenlängenabhängige Rückkopplung vom Reflektor so aufschaukelt, daß es zu Oszillationen von Laserleistung, Wellenlänge und Ladungsträgerdichte in der Lasersektion kommt.

Das Vorhandensein von zwei optisch gekoppelten Resonatoren, die unterschiedliche Modenkämme aufweisen die sich spektral so überlappen, daß eine definierte laser wellenlänge selektiert wird-ähnlich dem in der mechanik bekannten Noniusprinzip-, ist deshalb entscheidend für die Funktion des erfindungsgemäßen gütegesteuerten Halbleiterlasers, weil wegen der vielen möglichen Moden in einem einfachen Halbleiterlaser die Laseremission sonst nicht von der gewollten Mode getragen wird. Statt dessen würden konkurrierende Moden, bei denen höhere und nicht dispersive Reflexion auftritt, die Lasertätigkeit dominieren.

Die Ausbildung eines der Resonatoren als passiver Resonator ist deshalb wichtig, da der Brechungsindex hier eindeutig elektrisch von außen einstell- und fixierbar ist, während beim aktiven Resonator die Ladungsträgerdichte und damit Brechungsindex und Wellenlänge auch noch von der Photonendichte abhängen. Insgesamt ist also durch den Doppelresonator eine Lasermode selektiert, durch den passiven Resonator die Laserwellenlänge weitgehend fixiert, diese Wellenlänge aber bei elektrischer Ansteuerung des passiven Resonators in einem gewissen Wellenlängenbereich einstellbar. Eine annähernd spektrale Übereinstimmung der Laserwellenlänge mit der starken Dispersion in der Reflektorcharakteristik kann bei der Herstellung realisiert werden. Eine Feineinstellung wird durch elektrischen Offset bei der Ansteuerung von passivem Resonator bzw. Reflektor erreicht.

Die eigentliche Modulation erfolgt nun durch elektrische Steuerung (angelegtes elektrisches Feld oder Ladungsträgerinjektion) des Brechungsindexes des passiven Resonators oder durch elektrische Ansteuerung des Reflektors. Schon durch sehr kleine Änderungen der spektralen Korrelation von Laserwellenlänge zur spektral steilen Reflexionsflanke des Reflektors kann die Laserschwelle sehr effizient moduliert und so der Laser ohne Modulation der Netto-Verstärkung an- und ausgeschaltet werden.

Mit der erfindungsgemäßen Anordnung können hohe Modulationsfrequenzen erreicht werden, da nur kleine Hübe der Steuersignale notwendig sind. Gegenüber der Leistungsmodulation durch Laserstrommodulation wird ein wesentlich kleinerer Chirp (Wellenlängenmodulation) erreicht, da die Ladungsträgerdichte in dem aktiven Resonator nicht moduliert werden muß und außerdem durch den passiven Resonator eine Fixierung der Wellenlänge erfolgt.

Weitere vorteilhafte und zweckmäßige Einzelheiten der Erfindung sind in den Unteransprüchen angegeben. Hierzu gehört insbesondere die Ausgestaltung der Resonatorspiegel und der beiden optisch gekoppelten Resonatoren.

So ist in Ausführungsformen vorgesehen, den Reflektor mit stark dispersiver Reflexionscharakteristik als elektrisch bezüglich des Brechungsindexes abstimmbares DFB- oder DBR-Gitter oder als schmalbandiges Interferenzfilter auf einer Laserfacette auszubilden.

In einer weiteren Ausführungform weist der Reflektor Übergitter-Strukturen auf Solche Übergitter-Strukturen, die beispielsweise durch Phasensprünge oder Variation der Bragg-Wellenlänge bzw. des Kopplungskoeffizienten realisierbar sind, ermöglichen eine Modifizierung der Reflexionscharakteristik der homogenen DFB- und DBR-Gitter. Damit sind bereits während des Herstellungsprozesses des Halbleiterlasers die Voraussetzungen für die Realisierung gewünschter Übertragungsfunktionen/Schaltcharakteristiken technologisch in Abhängigkeit der Gitterstruktur und somit durch die Form der Reflexionscharakteristik einstellbar. So ist beispielsweise der Reflektor für die lineare Modulation mit einem Übergitter versehen, das einen linearen Anstieg auf der steilen Flanke der Stopbandkante der Reflexionscharakteristik realisiert, für das digitale Schalten mit einem solchen Übergitter, das an der erwähnten Flanke einen stufenförmigen Verlauf gewährleistet.

In einer Ausführungsform, die die Resonatoren betrifft, ist ein Resonator als aktive Lasersektion mit einem über dem optisch konstant gepumpten aktiven Medium angeordneten DFB-Gitter ausgebildet und der zweite Resonator als passive Sektion zwischen aktiver Lasersektion und dispersivem Reflektor angeordnet.

Eine andere Ausführungsform hierzu sieht vor, die oben erwähnte aktive Lasersektion zwischen dem zweiten als passive Sektion ausgebildeten Resonator und dem dispersiven Reflektor anzuordnen.

Wie bereits erwähnt, gewährleistet das Noniusprinzip, gemäß dem die beiden optisch gekoppelten Resonatoren entsprechende Modenkämme aufweisen, daß ein Anschwingen einer nicht gewollten Mode unterdrückt wird. Eine weitere Verbesserung kann dadurch erreicht werden, daß das in einem als aktive Lasersektion ausgebildeten Resonator vorhandene DFB-Gitter eine Bragg-Wellenlänge aufweist, die zu der des DFB- oder DBR-Gitters des Reflektors um ca. eine Stopbandbreite kurz- oder langwellig versetzt ist.

In einer weiteren Ausführungsform sind der passive und der aktive Resonator durch eine reflektierende Stoßstelle voneinander getrennt und die beiden Resonatoren von zwei Reflektoren begrenzt. Ist, nur ein Reflektor mit dispersiver Reflexionscharakteristik in der erfindungsgemäßen Anordnung enthalten, so ist der andere Reflektor eine reflektierende Facette.

Die optimale spektrale Korrelation Laser-Reflektor kann unabhängig von den elektrischen Arbeitsbedingungen eingestellt werden, wenn zusätzlich zur elektrischen Ansteuerung mindestens eine Sektion eine selektiv betreibbare Heizung aufweist, wie es in einer anderen Ausführungsform vorgesehen ist. Eine zusätzliche Heizung bewirkt eine Änderung des Brechungsindexes in der beheizten Sektion. Außerdem ist es mit einer derartigen Heizung möglich, technologische Toleranzen auszugleichen.

Weiterhin weist der passive Resonator eine laserartige Heterostruktur auf, die bei der Wellenlänge der Laseremission mittels Strominjektion auf Transparenz eingestellt ist. Eine solche laserartige Heterostruktur weist energetisch oberhalb der Bandbreite einen Transparenzpunkt bei kleineren Wellenlängen auf. Dabei muß die Heterostruktur elektrisch so gepumpt werden, daß bei der interessierenden Wellenlänge gerade der Umschlag von Lichtabsorption auf Lichtverstärkung stattfindet. Damit ist es möglich, den passiven Resonator mit Wellenlängen, die deutlich kleiner sind als die Laserwellenlänge, anzusteuern - es erfolgt eine Lichtabsorption - oder mit Wellenlängen, die innerhalb des Verstärkungsspektrums größer als die Laserwellenlänge sind - hierbei werden Ladungsträger verbraucht. Die Ansteuerung mit verschiedenen Wellenlängen ermöglicht somit ein optisch gesteuertes Schalten in zwei unterschiedlichen Richtungen.

Für eine hochfrequente elektrische Ansteuerung des Halbleiterlasers ist der passive Resonator aus zwei separat elektrisch ansteuerbaren Sektionen als Distanzstück ausgebildet. Durch das Vorhandensein zweier separat ansteuerbaren Sektionen wird der nötige Arbeitspunkt von der einen Sektion (Konstantstrom) und die reine HF-Modulation von der anderen Sektion realisiert. Damit muß der HF-Modulation kein Konstantwert überlagert werden. Eine elektronische Überlagerung von HF-Steuersignalen und konstanten Strömen/Spannungen ist deshalb nicht notwendig.

Für die Realisierung von logischen Operationen, beispielsweise für die logische Verknüpfung von zwei Signalen, müssen die Sektionen des Halbleiterlasers selektiv - elektrisch oder optisch - ansteuerbar sein. Der erfindungsgemäße Halbleiterlaser wird dann so eingestellt, daß er nur bei gleichzeitiger Ansteuerung von zwei unterschiedlichen Sektionen digital ein- oder ausschaltbar ist. Die folgenden Ausführungsformen erfüllen diese Voraussetzungen. So ist vorgesehen, daß die einzelnen Sektionen selektiv mit unterschiedlichen hochfrequenten elektrischen Signalen angesteuert sind. Weiterhin kann in der Schichtebene der Halbleiterlaserstruktur quer zur Laserachse eine wellenleitende Struktur mindestens an eine Sektion des Halbleiterlasers geführt sein, über die optische Signale selektiv in diese Sektion eingestrahlt sind. Es ist auch möglich, daß in einen elektrischen, ein optisches Fenster aufweisenden oder semitransparent ausgebildeten Kontakt mindestens einer Sektion optische Signale selektiv in diese Sektion eingestrahlt sind.

Die Erfindung ist in ihrer Ausführung nicht auf die vorstehend beschriebenen Formen beschränkt, sondern umfaßt alle Varianten, die den Erfindungsgedanken realisieren.

Nachfolgend werden Ausführungsbeispiele der Erfindung anhand der Zeichnungen näher erläutert.

Dabei zeigen:
- Fig. 1: schematisch den Aufbau eines erfindungsgemäßen gütegesteuerten Halbleiterlasers, bestehend aus einem passiven und einem aktiven Resonator und einem dispersiven Reflektor, bei dem der passive Resonator zwischen Reflektor und aktivem Resonator angeordnet ist;
- Fig. 2: einen Querschnitt des in Fig. 1 dargestellten gütegesteuerten Halbleiterlasers;
- Fig. 3: die Abhängigkeit der Reflektivität des Reflektors von der Wellenlänge;
- Fig. 4: zusätzlich zu der in Fig. 3 dargestellten Abhängigkeit der Reflektivität des Reflektors von der Wellenlänge die spektrale Charakteristik eines DFB-Lasers bei Versatz der beiden Bragg-Wellenlängen zueinander;
- Fig. 5: die optischen Spektren des in Fig. 1 und 2 dargestellten Lasers, wenn der passive Resonator mit unterschiedlichen Strömen gesteuert wird;
- Fig. 6: die Abhängigkeit der optischen Leistung von der Zeit, wenn der passive Resonator des in Fig. 1 und 2 dargestellten Lasers mit einem sinusförmig mit 1 GHz moduliertem Strom I gesteuert wird;
- Fig. 7: einen Querschnitt eines gütegesteuerten Halbleiterlasers, bei dem der aktive Resonator zwischen dem passiven Resonator und dem dispersiven Reflektor angeordnet ist;
- Fig. 8: einen Querschnitt eines gütegesteuerten Halbleiterlasers, bei dem der aktive und passive Resonator durch eine reflektierende Stoßstelle voneinander getrennt sind.

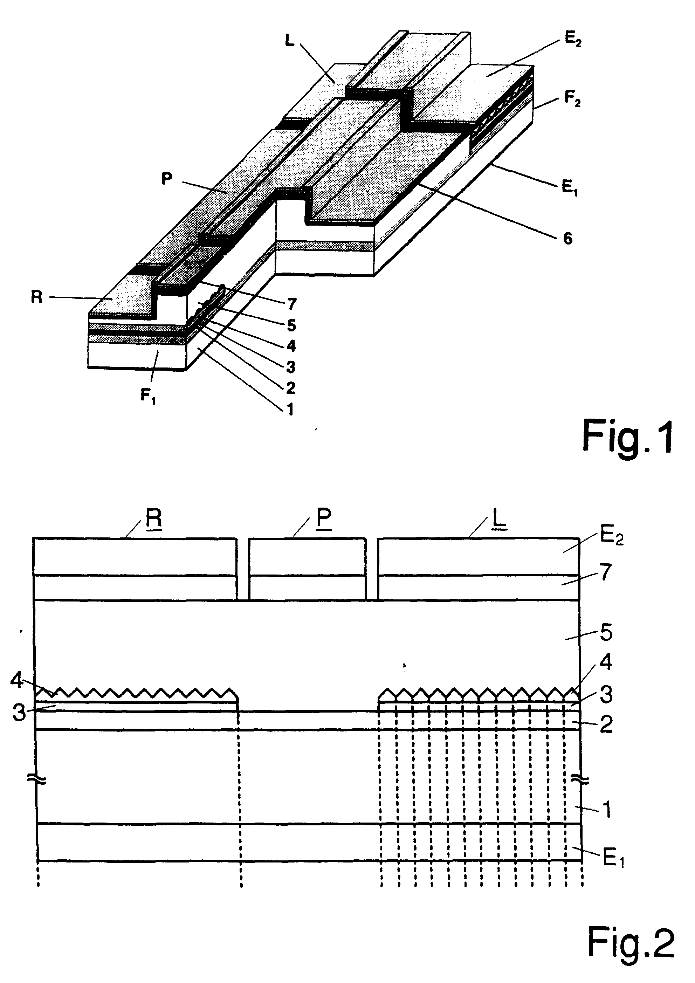

In Fig. 1 ist ein gütegesteuerter Halbleiterlaser, bestehend aus einem als Lasersektion **L** mit DFB-Gitter ausgebildeten aktiven Resonator, einem passiven Resonator **P** und einem ebenfalls als DFB-Gitter ausgebildeten Reflektor **R** mit einer stark dispersiven Reflexionscharakteristik im Bereich der durch den Doppelresonator selektierten Laserwellenlänge, in Rippenwellenleiterstruktur dargestellt.

Auf einem n-InP-Substrat **1** ist zwischen einer 300 nm dicken n-1,3 µm-InGaAsP-Wellenleiterschicht **2** und einer 150 nm dicken p-1,18 µm-InGaAsP-Wellenleiterschicht **4** eine 1,55 µm-InGaAsP-Schicht als aktive Schicht **3** mit einer Dicke von 150 nm angeordnet. Das DFB-Gitter wurde mittels Elektronenstrahllithographie eingeschrieben und in den p-Wellenleiter **4** geätzt. Darauf befinden sich eine p-InP-Schicht **5** und eine isolierende, nur an der Rippe geöffnete, SiNₓ-Schicht **6**, die von einer Elektrodenschicht **E**_{**2**} bedeckt ist. Der Mittelstreifen der Rippenwellenleiterstruktur weist außerdem zur Verringerung des Übergangswiderstandes eine 400 nm dicke p-InGaAs-Schicht **7** auf. Die Lasersektion L hat eine Länge von 300 µm, die passive Resonatorsektion **P** von 400 µm und der dispersive Reflektor **R** von 200 µm. Das Substrat **1** ist auf einer Basiselektrode **E**_{**1**} angeordnet. Reflektor **R** und aktiver Resonator **L** werden jeweils von einer antireflexionsbeschichteten Facette **F**_{**1**}**, F**_{**2**} begrenzt.

In Fig. 2 ist der gleiche gütegesteuerte Halbleiterlaser, bei dem die passive Resonatorsektion **P** zwischen aktivem Resonator **L** und Reflektor **R** angeordnet ist, im Querschnitt dargestellt. Der Schnitt wurde in Längsrichtung durch den erhöhten Mittelstreifen der Rippenwellenleiterstruktur geführt. Deutlich zu erkennen ist die ähnliche Schichtstruktur der beiden Resonatoren **L** und **P** und des dispersiven Reflektors **R**. Die Schichtstruktur weist folgende Schichten auf: eine Basiselektrode **E**_{**1**}, ein n-InP-Substrat **1**, eine n-InGaAsP-Wellenleiterschicht **2**, eine aktive InGaAsP-Schicht **3**, eine p-InGaAs-Wellenleiterschicht **4** mit DFB-Gitter, eine p-InP-Schicht **5** und eine geteilte Deckelektrode **E**_{**2**} zur getrennten Ansteuerung der beiden Resonatoren **L** und **P** und des Reflektors **R**, unter der sich eine p-InGaAs-Schicht **7** befindet.

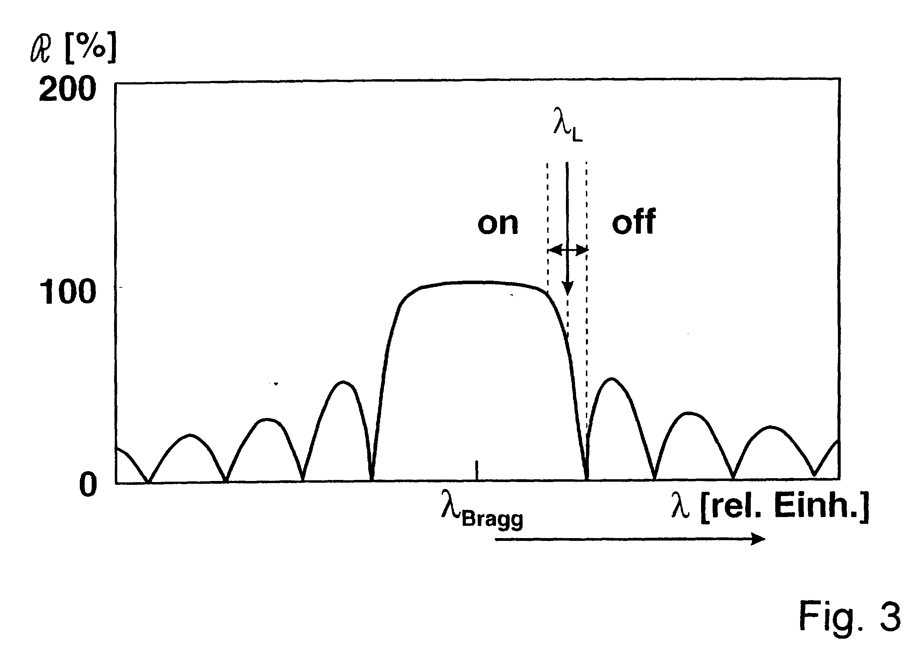

In Fig. 3 ist die Abhängigkeit der Reflektivität 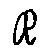 des Reflektors **R** von der Wellenlänge λ bei Betrieb nahe der Transparenzstromdichte dargestellt. Störende konkurrierende Laserwellenlängen werden durch die beiden unterschiedlichen Resonatorbedingungen der Lasersektion **L** und des passiven Resonators **P** ähnlich dem Noniusprinzip in der mechanischen ließtechnik für die Lasermoden ausgeblendet, eine passive Phasenbedingung fixiert die Wellenlänge. Der gütegesteuerte Halbleiterlaser kann dadurch bei festem Pumpstrom in der Leistung moduliert werden. Die Modulation erfolgt durch elektrische Variation der passiven Resonatorbedingung oder der spektralen Reflektorlage. Mit einer nur geringen Änderung der spektralen Reflektorlage kann - wie das aus Fig. 3 ersichtlich ist - bei fixierter Laserwellenlänge **λ**_{**L**}, die ja bereits bei der Herstellung des gütegesteuerten Lasers in annähernde spektrale Übereinstimmung mit der starken Dispersion in der Reflektorcharakteristik - vorzugsweise im Bereich ihrer steilen Flanke - gebracht wurde, gezielt der dispersive Reflektor **R** in den Strahlengang des gütegesteuerten Halbleiterlasers elektrisch ein- und ausgeschaltet werden. Das hat zur Folge, daß die Laserschwelle sehr effizient, d.h. durch sehr kleine Stromänderungen oder Spannungshübe, moduliert wird.

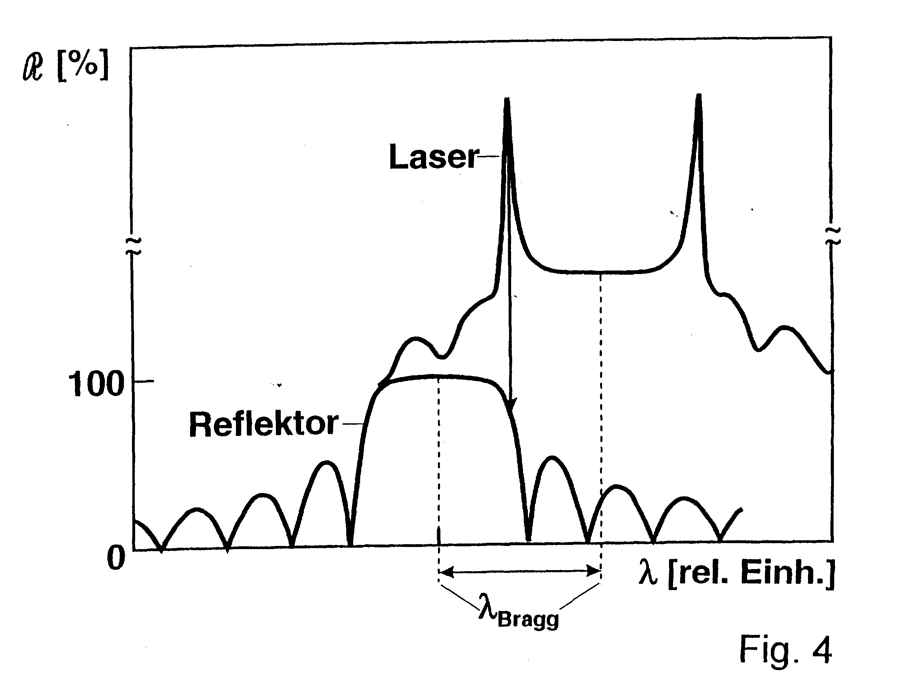

In Fig. 4 ist wiederum die Reflektivität 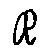 des Reflektors **R** in Abhängigkeit von der Wellenlänge λ und nun - im Vergleich zu Fig. 3 - außerdem die spektrale Charakteristik eines DFB-Lasers dargestellt. DFB-Laser haben zwei nahezu gleichberechtigte Moden kurz- und langwellig vom Stopband. Für die dispersive Gütemodulation muß das Anschwingen einer nicht gewollten Mode unterdrückt werden, was hierbei durch Selektion einer definierten Laserwellenlänge-ähnlich dem bereits erwähnten Noniusprinzip in der mechanischen heßtechnik- zwischen DFB-Moden und passiven Resonatormoden erreicht wird. Eine verbesserte Unterdrückung der nicht gewollten Mode wird erreicht, wenn die Bragg-Wellenlängen von DFB-Laser und DFB- oder DBR-Reflektor um ca. eine Stopbandbreite gegeneinander versetzt sind, wie das in Fig. 4 gezeigt ist. Dann korreliert z.B. die kurzwellige Lasermode mit dem Reflexionsabfall auf der langwelligen Seite des Reflektor-Stopbandes, während die langwellige Lasermode keinen spektralen Überlapp mit der hohen Reflektivität im Stopband hat und somit kaum zur Lasertätigkeit anschwingen kann.

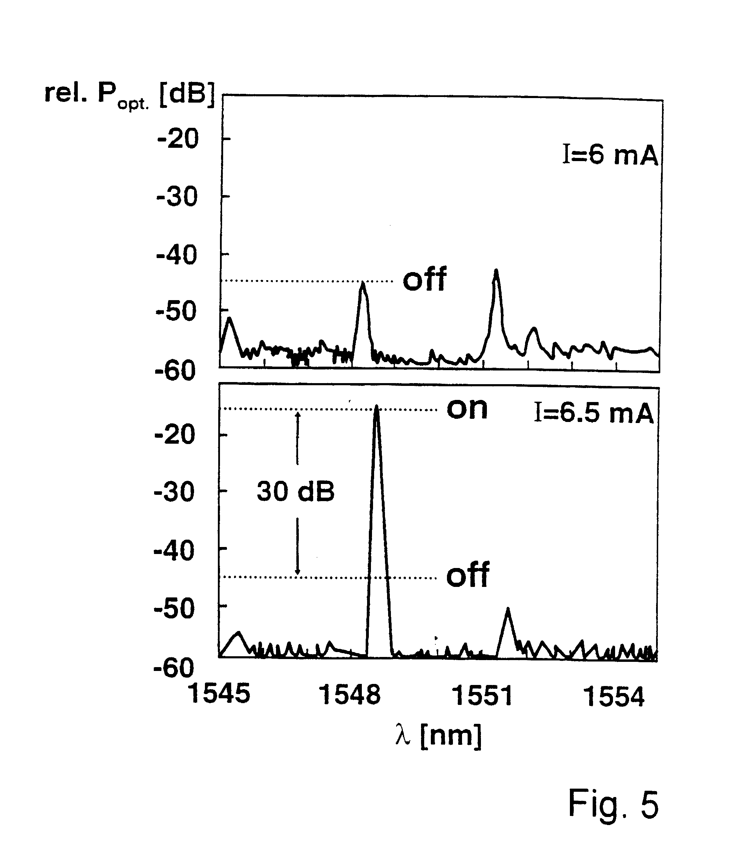

In Fig. 5 ist die relative optische Leistung **P**_{**opt**} eines erfindungsgemäßen gütegesteuerten Halbleiterlasers mit einem in Fig. 1 bzw. Fig. 2 dargestellten Aufbau in Abhängigkeit der Wellenlänge λ bei verschiedenen Strömen, mit denen der passive Resonator **P** gespeist wurde, gezeigt. Die Lasersektion **L** mit DFB-Gitter wird bei einem solch geringen Strom (hier 41 mA) betrieben, daß nur durch Zu- bzw. Einschalten einer zusätzlichen Reflektivität der Laser zu schwingen beginnt. Der dispersive Reflektor **R** mit DFB-Gitter wird mit 16 mA gesteuert. Wird nun der passive Resonator **P** mit unterschiedlichen Strömen **I** (hier: 6 mA und 6,5 mA) betrieben, ist ein Ein- und Ausschalten des erfindungsgemäßen Halbleiterlasers zu beobachten. Bei einem Strom von 6,5 mA ist eine Monomode-Emission bei einer Wellenlänge λ = 1548 nm zu beobachten; wird der Strom I nun um 0,5 mA auf 6,0 mA reduziert, wird der Laser ausgeschaltet. Hierbei wird ein Schaltkontrast von größer 30 dB erreicht. Da die Ströme und somit die Verstärkung der Lasersektion **L** und des Reflektors **R** fixiert sind, wird durch diese Kurven das dispersive Schwellschalten des gütegesteuerten Halbleiterlasers belegt, denn nur durch kleine Änderungen (0,5 mA) des Stromes, mit dem der passive Resonator **P** gespeist wird, wird - bei festem Pumpstrom - der Laser an- und ausgeschaltet.

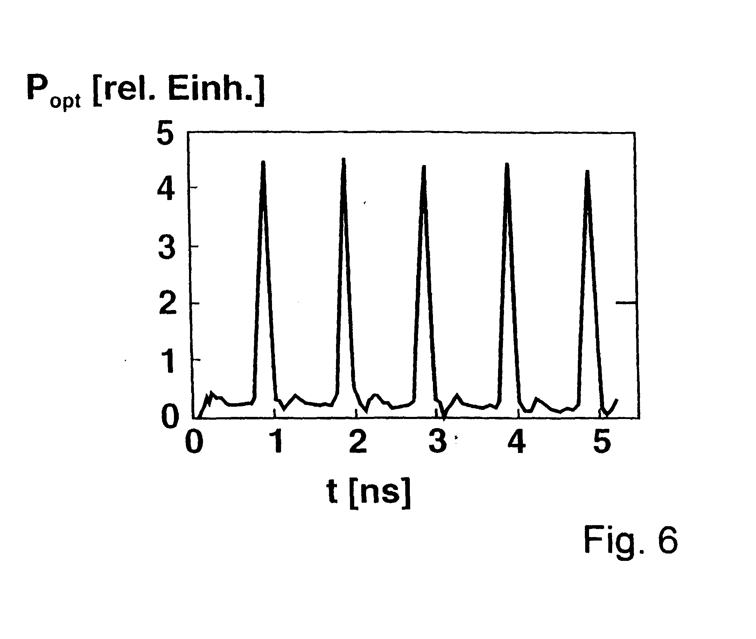

Wird nun der Strom **I**, mit dem der passive Resonator **P** gespeist wird, sinusförmig mit 1 GHz moduliert, wird ein Pulszug (optische Leistung **P**_{**opt**} in Abhängigkeit von der Zeit **t**), wie er in Fig. 6 dargestellt ist, generiert. Da die oben beschriebene Anordnung nicht für HF-Operationen/Betrieb optimiert wurde, sind mit großer Wahrscheinlichkeit auch höhere Modulationsfrequenzen möglich.

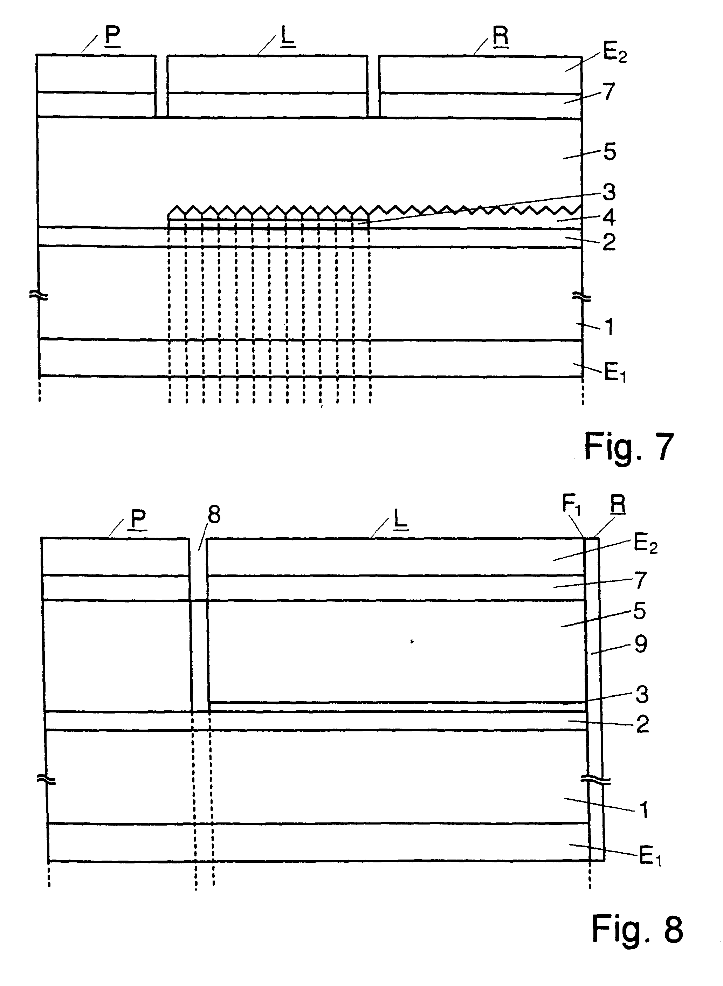

In Fig. 7 und 8 sind weitere Ausführungsformen des erfindungsgemäßen gütegesteuerten Halbleiterlasers im Querschnitt dargestellt.

In Fig. 7 ist der aktive Resonator **L**, der Lasersektion mit DFB-Gitter, zwischen dem passiven Resonator **P** und einem als DBR-Gitter ausgebildeten Reflektor **R** angeordnet. Der Schichtaufbau ist der gleiche wie bereits zu Fig. 2 beschrieben.

Fig. 8 zeigt einen als Fabry-Perot-Laser ausgebildeten aktiven Resonator **L**, der von dem passiven Resonator **P** durch eine - schematisch dargestellte - reflektierende Stoßstelle **8**, beispielsweise einen Ätzgraben einer Breite im µm-Bereich, bei dem zur Erzielung nur einer Spiegelfläche in Resonatorrichtung eine Flanke senkrecht zum Laserstrahl und eine schräg hierzu ausgebildet ist. Auf einer Laserfacette - hier **F**_{**1**} - ist ein Interferenzfilter **9** angeordnet. Die andere Facette, hier nicht dargestellt, ist reflektierend ausgebildet.

Die senkrechten gestrichelten Linien in den Figuren 2, 7 und 8 sollen die Wirkung eines "verteilten" Reflektors gemäß der erfindungsgemäßen Lösung verdeutlichen.

Der erfindungsgemäße gütegesteuerte Halbleiterlaser benötigt zur Modulation nur geringe Ströme bzw. Spannungshübe, da nicht ein hoher Laserstrom, sondern kleine Steuerströme moduliert werden, die einen großen Einfluß auf die Laserschwelle haben. Damit ist er besonders für eine schnelle Modenschaltung anwendbar, d.h. nicht der Laser selbst wird ein- und ausgeschaltet, sondern zu einer bereits wirksamen Mode wird die Schwelle einer anderen Mode so herabgesetzt, daß die ausgewählte Mode nun anspringt und dominiert.

Die erfindungsgemäße Lösung des gütegesteuerten Halbleiterlasers ermöglicht sowohl ein analoges Steuern als auch ein digitales Schalten, da in Abhängigkeit des Arbeitspunktes und der Steuerart die Laserleistung entweder proportional zur Steuergröße verändert oder ein sprunghaftes digitales Umschalten mit einer Hysterese (Haltefunktion) erreicht werden kann.

Anstelle der Steuerung mittels elektrischen Stromes ist es auch möglich, durch Lichteinstrahlung in den erfindungsgemäßen Halbleiterlaser eine Änderung der Ladungsträgerdichte zu bewirken. Da die Transparenz einer Schicht immer von der Wellenlänge abhängt, können auch "passive" Resonatoren angesteuert werden, wenn eine geeignete Wellenlänge unterschiedlich zur Laserwellenlänge benutzt wird. So hat die Wellenleiterschicht **2** in den Ausführungsbeispielen eine Bandkante von 1,3 µm, absorbiert also Licht kleinerer Wellenlängen als die aktive Schicht 3, wobei Ladungsträger erzeugt werden. Bei einer als Reflektor eingesetzten DFB-Sektion kann erreicht werden, daß DFB-Wellenlänge und Verstärkungsmaximum der aktiven Schicht spektral getrennt sind, so daß eingestrahltes Licht geeigneter Wellenlänge verstärkt und dabei die Ladungsträgerdichte vermindert wird. Für die Realisierung dieser optischen Ansteuerung erweist es sich wiederum von Vorteil, daß der erfindungsgemäße Halbleiterlaser nur kleine Steuerleistungen benötigt.

## Patentansprüche

1. Gütegesteuerter Halbleiterlaser, bestehend aus mindestens zwei elektrisch getrennten aber optisch gekoppelten Resonatoren, von denen der eine als passiver und der andere als aktiver Resonator ausgebildet ist,
**dadurch gekennzeichnet, daß**
- die beiden optisch gekoppelten Resonatoren zur Lasermoden-Selektion unterschiedlich ausgebildete Modenkämme aufweisen, die sich spektral so überlappen, daß eine definierte Laserwellenlänge selektiert wird,
- mindestens ein Resonatorspiegel der beiden optisch gekoppelten Resonatoren als Reflektor (R) mit einer stark dispersiven Reflexionscharakteristik ( 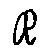 ) im Bereich der durch die beiden optisch gekoppelten Resonatoren selektierten Laserwellenlänge ausgebildet ist,
- Mittel zur elektrischen oder optischen Abstimmung des Brechungsindex des dispersiven Reflektors (R) und/oder des passiven Resonators (P) vorgesehen sind, so daß eine spektrale Steuerung der Lasermode relativ zum dispersiven Reflektor (R) erfolgt.

2. Gütegesteuerter Halbleiterlaser nach Anspruch 1,
**dadurch gekennzeichnet, daß**
der Reflektor (R) mit stark dispersiver Reflexionscharakteristik ( 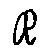 ) als elektrisch bezüglich des Brechungsindexes abstimmbares DFB-Gitter ausgebildet ist.

3. Gütegesteuerter Halbleiterlaser nach Anspruch 1,
**dadurch gekennzeichnet, daß**
der Reflektor (R) mit stark dispersiver Reflexionscharakteristik ( 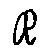 ) als elektrisch bezüglich des Brechungsindexes abstimmbares DBR-Gitter ausgebildet ist.

4. Gütegesteuerter Halbleiterlaser nach Anspruch 2 oder 3,
**dadurch gekennzeichnet, daß**
der Reflektor (R) Übergitter-Strukturen aufweist.

5. Gütegesteuerter Halbleiterlaser nach Anspruch 1,
**dadurch gekennzeichnet, daß**
der Reflektor (R) mit stark dispersiver Reflexionscharakteristik ( 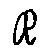 ) als schmalbandiges Interferenzfilter (9) auf einer Laserfacette (F₁) ausgebildet ist.

6. Gütegesteuerter Halbleiterlaser nach mindestens einem der vorangehenden Ansprüche,
**dadurch gekennzeichnet, daß**
ein Resonator als aktive Lasersektion (L) mit einem über dem optisch konstant gepumpten aktiven Medium angeordneten DFB-Gitter ausgebildet und der zweite Resonator als passive Sektion (P) zwischen aktiver Lasersektion (L) und dispersivem Reflektor (R) angeordnet ist.

7. Gütegesteuerter Halbleiterlaser nach mindestens einem der Ansprüche 1 bis 5,
**dadurch gekennzeichnet, daß**
ein Resonator als aktive Lasersektion (L) mit einem über dem optisch konstant gepumpten aktiven Medium angeordneten DFB-Gitter ausgebildet und zwischen dem zweiten als passive Sektion (P) ausgebildeten Resonator und dispersivem Reflektor (R) angeordnet ist.

8. Gütegesteuerter Halbleiterlaser nach Anspruch 2, 3 und 6 oder 7,
**dadurch gekennzeichnet, daß**
das in einem als aktive Lasersektion (L) ausgebildeten Resonator vorhandene DFB-Gitter eine Bragg-Wellenlänge aufweist, die zu der des DFB- oder DBR-Gitters des Reflektors (R) um ca. eine Stopbandbreite kurz- oder langwellig versetzt ist.

9. Gütegesteuerter Halbleiterlaser nach mindestens einem der Ansprüche 1 bis 5,
**dadurch gekennzeichnet, daß**
passiver und aktiver Resonator durch eine reflektierende Stoßstelle (8) voneinander getrennt und die beiden Resonatoren von zwei Reflektoren begrenzt sind.

10. Gütegesteuerter Halbleiterlaser nach einem der Ansprüche 1, 6, 7 oder 9,
**dadurch gekennzeichnet, daß**
zusätzlich zur elektrischen Ansteuerung mindestens eine Sektion eine selektiv betreibbare Heizung aufweist.

11. Gütegesteuerter Halbleiterlaser nach einem der Ansprüche 1, 6, 7 oder 9,
**dadurch gekennzeichnet, daß**
der passive Resonator eine laserartige Heterostruktur aufweist, die bei der Wellenlänge der Laseremission mittels Strominjektion auf Transparenz eingestellt ist.

12. Gütegesteuerter Halbleiterlaser nach einem der Ansprüche 1, 6, 7 oder 9,
**dadurch gekennzeichnet, daß**
der passive Resonator aus zwei separat elektrisch ansteuerbaren Sektionen als Distanzstück ausgebildet ist.

13. Gütegesteuerter Halbleiterlaser nach Anspruch 12,
**dadurch gekennzeichnet, daß**
eine der beiden separat elektrisch ansteuerbaren Sektionen des passiven Resonators eine laserartige Heterostruktur aufweist, die bei der Wellenlänge der Laseremission mittels Strominjektion auf Transparenz eingestellt ist.

14. Gütegesteuerter Halbleiterlaser nach mindestens einem der vorangehenden Ansprüche,
**dadurch gekennzeichnet, daß**
die einzelnen Sektionen selektiv mit unterschiedlichen hochfrequenten elektrischen Signalen angesteuert sind.

15. Gütegesteuerter Halbleiterlaser nach mindestens einem der vorangehenden Ansprüche,
**dadurch gekennzeichnet, daß**
in der Schichtebene der Halbleiterlaserstruktur quer zur Laserachse eine wellenleitende Struktur mindestens an eine Sektion des Halbleiterlasers geführt ist, über die optische Signale selektiv in diese Sektion eingestrahlt sind.

16. Gütegesteuerter Halbleiterlaser nach mindestens einem der vorangehenden Ansprüche,
**dadurch gekennzeichnet, daß**
in einen elektrischen, ein optisches Fenster aufweisenden oder semitransparent ausgebildeten Kontakt mindestens einer Sektion optische Signale selektiv in diese Sektion eingestrahlt sind.

## Claims

1. Q-switched semiconductor laser consisting of at least two electrically separated but optically coupled resonators one of which is structured as a passive resonator and the other one of which is structured as an active resonator,
**characterized by the fact**, that
- for laser mode selection the two optically coupled resonators have differently structured mode combs which spectrally overlap such that a defined wavelength is selected;
- at least one resonator reflector ot the two optically coupled resonators ist structured as a reflector (R) with a strongly dispersive reflection characteristic ( 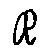 ) in the range of the laser wavelength selected by the two optically coupled resonators;
- means are provided for electrically or optically tuning the refractive index of the dispersive reflector (R) and/or of the passive reflector (P) so that spectral control ot the laser mode is accomplished relative to the dispersive reflector (R).

2. Q-switched semiconductor laser according to claim 1,
**characterized by the fact,** that
the reflector (R) of strongly dispersive reflection characteristic ( 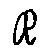 ) is structured as a DFB grid electrically tunable relative to the refractive index.

3. Q-switched semiconductor laser according to claim 1,
**characterized by the fact**, that
the reflector (R) of strongly dispersive reflection characteristic ( 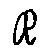 ) is structured as a DBR grid electrically tunable relative to the refractive index.

4. Q-switched semiconductor laser according to claim 2 or 3,
**characterized by the fact**, that
the reflector (R) is provided with supergrid structures.

5. Q-switched semiconductor laser according to claim 1,
**characterized by the fact**, that
the reflector (R) of strongly dispersive reflection characteristic ( 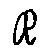 ) is structured as a narrow-band interference filter (9) on a laser facet (F₁).

6. Q-switched semiconductor laser according to at least one of the preceding claims,
**characterized by the fact**, that
one resonator is structured as active laser section (L) with a DFB grid arranged above the optically constantly pumped active medium and the second resonator is arranged as a passive section (P) between the active laser section (L) and the dispersive reflector (R).

7. Q-switched semiconductor laser according to at least one of claims 1 to 5,
**characterized by the fact**, that
one reonator is structured as active laser section (L) with a DFB grid arranged above the optically constantly pumped active medium and is arranged between the second resonator structured as a passive section (P) and the dispersive reflector (R).

8. Q-switched semiconductor laser according to claim 2, 3 and 6 or 7,
**characterized by the fact**, that
the DFB grid in a resonator structured as active laser section (L) is of a Bragg wavelength which is displaced by approximatly one stopband width in the short or long wave direction relative to that of the DFB or DBR grid of the reflector (R).

9. Q-switched semiconductor laser according to at least one of claims 1 to 5,
**characterized by the fact**, that
passive and active resonators are separated from each other by a reflective interface (8) and that the resonators are limited by two reflectors.

10. Q-switched semiconductor laser according to one of claims 1, 6, 7 or 9,
**characterized by the fact**, that
in addition to the electrical control at least one section is provided with a selctively actuable heater.

11. Q-switched semiconductor laser according to one of claims 1, 6, 7 or 9,
**characterized by the fact**, that
the passive resonator is of a laser-like hetero structure which at the laser emission wavelength is set to transparency by current injection.

12. Q-switched semiconductor laser according to one of claims 1, 6, 7 or 9,
**characterized by the fact**, that
the pasive resonator is structred as a separator of two separately electrically controllable sections.

13. Q-switched semiconductor laser according to claim 12,
**characterized by the fact**, that
one of the two separately electrically controllable sections of the passive resonator has a laser-like structure which at the wavelength of laser emission is set to transparency by current injection.

14. Q-switched semiconductor laser according to at least one of the preceding claims,
**characterized by the fact**, that
the individual sections are selectively controlled by different high-frequency electrical signals.

15. Q-switched semiconductor laser according to at least one of the preceding claims,
**characterized by the fact,** that
one waveguide structure is abuts on at least one section of the semiconductor laser in the layer plane of the semiconductor laser structure at right angles to the laser axis whereby the optical signals are selectively fed into this section.

16. Q-switched semiconductor laser according to at least one of the preceding claims,
**characterized by the fact**, that
optical signals are selectively fed into a section by way of an electrical contact in this section which contact is provided with an optical window or is structured semitransparently.

## Revendications

1. Laser à semi-conducteur, déclenché, composé d'au moins deux résonateurs séparés électriquement mais couplés optiquement, dont l'un est un résonateur passif et l'autre un résonateur actif,
caractérisé en ce que
- les deux résonateurs à couplage optiques présentent des peignes de mode différents pour la sélection des modes laser, ces peignes se chevauchant spectralement pour sélectionner une longueur d'onde laser, définie,
- au moins un miroir des deux résonateurs à couplage optique est réalisé comme réflecteur (R) ayant une caractéristique de réflexion à forte dispersion ( 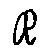 ) dans la plage de la longueur d'onde de laser sélectionnée par les deux résonateurs à couplage optique,
- des moyens pour accorder électriquement ou optiquement l'indice de réfraction du réflecteur à dispersion (R) et/ou du résonateur passif (P) pour une commande spectrale du mode laser par rapport au réflecteur dispersif (R).

2. Laser à semi-conducteur déclenché selon la revendication 1,
caractérisé en ce que
le réflecteur (R) à caractéristique de réflexion à forte dispersion ( 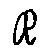 ) est réalisé comme réseau DFB accordé électriquement par rapport à l'indice de réfraction.

3. Laser à semi-conducteur déclenché selon la revendication 1,
caractérisé en ce que
le réflecteur (R) à caractéristique de réflexion à forte dispersion ( 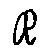 ) est réalisé comme réseau DBR accordé vis-à-vis de l'indice de réfraction.

4. Laser à semi-conducteur déclenché selon la revendication 2 ou 3,
caractérisé en ce que
le réflecteur (R) présente des structures au-dessus du réseau.

5. Laser à semi-conducteur déclenché selon la revendication 1,
caractérisé en ce que
le réflecteur (R) à caractéristique de réflexion à forte dispersion ( 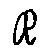 ) est réalisé comme un filtre d'interférence (9) à bande étroite sur une facette de laser (F₁).

6. Laser à semi-conducteur déclenché selon au moins l'un des revendications précédentes,
caractérisé en ce que
le résonateur est réalisé comme section active de laser (L) avec un réseau DFB prévu au-dessus du milieu actif à pompage optique constant et le second résonateur est prévu comme section passive (P) entre la section active de laser (L) et le réflecteur dispersif (R).

7. Laser à semi-conducteur déclenché selon au moins l'une des revendications 1 à 5,
caractérisé en ce que
le résonateur est une section active de laser (L) avec un réseau DFB placé au-dessus du milieu actif pompé optiquement constant et entre le second résonateur réalisé comme section passive (P) et le réflecteur dispersif (R).

8. Laser à semi-conducteur déclenché selon les revendications 2, 3 et 6 ou 7,
caractérisé en ce qu'
un réseau DFB existant dans un résonateur en forme de section active de laser (L) présente une longueur d'onde de Bragg décalée vis-à-vis du réseau DFB ou DBR du réflecteur (R) d'environ une largeur de bande d'arrêt de courte longueur d'onde ou de grande longueur d'onde.

9. Laser à semi-conducteur déclenché selon au moins l'une des revendications 1 à 5,
caractérisé en ce que
le résonateur passif et le résonateur actif sont séparés l'un de l'autre par un point de jonction réfléchissant (8) et les deux résonateurs sont délimités par des réflecteurs.

10. Laser à semi-conducteur déclenché selon l'une des revendications 1, 6, 7 ou 9,
caractérisé en ce qu'
il comprend en plus de la commande électrique au moins une section d'un chauffage électrique commandé.

11. Laser à semi-conducteur déclenché selon l'une des revendications 1, 6, 7 ou 9,
caractérisé en ce que
le résonateur passif présente une structure hétérogène de type laser qui est réglée en transparence par injection de courant à la longueur d'onde de l'émission laser.

12. Laser à semi-conducteur déclenché selon l'une des revendications 1, 6, 7 ou 9,
caractérisé en ce que
le résonateur passif est formé de deux sections à commande électrique séparées comme pièces d'écartement.

13. Laser à semi-conducteur déclenché selon la revendication 12,
caractérisé en ce que
l'une des deux sections à commande électrique séparées du résonateur passif présente une structure hétérogène de type laser dont la longueur d'onde de l'émission laser se règle en transparence par une injection de courant.

14. Laser à semi-conducteur déclenché selon au moins l'une des revendications précédentes,
caractérisé en ce que
les différentes sections sont commandées de manière sélective avec des signaux électriques haute fréquence différents.

15. Laser à semi-conducteur déclenché selon au moins l'une des revendications précédentes,
caractérisé en ce que
dans le plan de stratification de la structure de laser à semi-conducteur, transversalement à l'axe du laser, une structure de guide d'ondes arrive sur au moins une section du laser à semi-conducteur pour injecter les signaux optiques de manière sélective dans cette section.

16. Laser à semi-conducteur déclenché selon au moins l'une des revendications précédentes,
caractérisé
par un contact électrique ayant une fenêtre optique ou un contact semi-transparent pour au moins une section pour injecter des signaux optiques sélectivement dans cette section.
